# EUROPEAN PATENT APPLICATION

(11) **EP 1 394 937 A2**
(43) Date of publication of application: **03.03.2004**
(21) Application number: 03255291.1
(22) Date of filing: 26.08.2003
(51) Int. Cl.: H03G 3/20, H03K 17/00, H03K 17/693

(54) **Switching circuit**

(30) Priority: 27.08.2002 JP 2002246511
(71) Applicant: ALPS ELECTRIC CO., LTD., Ota-ku Tokyo 145 (JP)
(72) Inventor: Yatsuda, Senichiro, Tokyo 145 (JP)
(74) Representative: Kensett, John Hinton

(57) **Abstract**

Included are a signal source (1), and switching means (2) for connecting the signal source to a first load circuit (3) or a second load circuit(4). Emission attenuation means (5) is also provided between the signal source and the switching means for attenuating a signal to be emitted from the switching means in a time period at least between the signal source being cut off from either the first or second load circuit and being connected to the other. Such a structure stops signal jumping to other circuits, successfully lowering the signal level.

## Description

### BACKGROUND OF THE INVENTION

### FIELD OF THE INVENTION

The present invention relates to a switching circuit for switching a load circuit connected to a signal source.

### DESCRIPTION OF THE RELATED ART

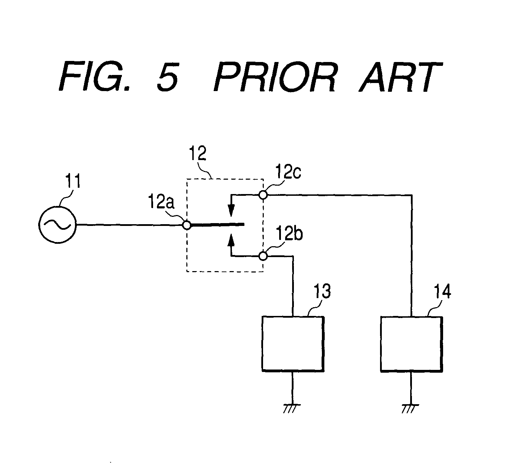

FIG. 5 shows a conventional switching cir cuit. In the drawing, a signal output from a signal source 11 is provided to a load circuit 13 or 14 via switching means 12. The switching means 12 is the one structured by a switch circuit of a single-pole double-throw type, for example. Therein, provided are an input terminal 12a connected to the signal source 11, and output terminals 12b and 12c connected to the load circuits 13 and 14, respectively. The input terminal 12a is connected to either the output terminal 12b or 12c. In a case where the input terminal 12a is currently connected to the output terminal 12b but is to be connected to the output terminal 12c, it takes about 1 µS (micro second) for the input terminal 12a to be cut off from the output terminal 12b and connected to the output terminal 12c. During this switching period, the input terminal 12a is connected neither the output terminal 12b nor 12c.

### SUMMARY OF THE INVENTION

During such a switching period, no connection is established between the signal source and the load circuit. Therefore, the input terminal in the switching means becomes open, and resultantly the signal source suffers large load fluctuation and signal emission occurs at the input terminal. As a result, this causes the signal resource to be unstable in operation and the emitted signal to jump to other circuits, blocking circuit operation.

An object of the present invention is to reduce signal emission in a switching period, successfully causing less impact on other circuits, and stabilizing a signal source.

According to an aspect of the present invention there is provided a switching circuit, comprising a signal source, and switching means for connecting the signal source to a first load circuit or a second load circuit. Emission attenuation means is also provided for attenuating a signal to be emitted from the switching means between the signal source and the switching means in a time period at least between the signal source being cut off from either the first or second load circuit and being connected to the other.

Preferably, the emission attenuation means includes a third load circuit, and the third load circuit is connected to the signal source in a time period at least before the signal source being cut off from either the first or second load circuit to after being connected to the other.

Preferably, an impedance of the third load circuit is so set as to be almost an average value between an impedance of the first load circuit and an impedance of the second load circuit.

Preferably, the emission attenuation means includes an amplifier, and a gain of the amplifier is attenuated in the time period at least before the signal source being cut off from either the first or second load circuit to after being connected to the other.

Preferably, the gain of the amplifier is attenuated by changing a bias voltage of an amplification element in the amplifier.

Preferably, the signal source is structured by a voltage control oscillator.

Embodiments of the present invention will now be described, by way of example, with reference to the accompanying drawings, in which:
FIG. 1 is a circuit diagram showing a switching circuit in a first embodiment of the present invention;
FIG. 2 is a timing chart showing a connection condition at the time of switching of the switching circuit in the first embodiment of the invention;
FIG. 3 is a circuit diagram showing a switching circuit in a second embodiment of the invention;
FIG. 4 is a timing chart showing a gain change occurring at the time of switching of the switching circuit in the second embodiment of the invention; and
FIG. 5 is a circuit diagram showing the structure of a conventional switching circuit.

### DESCRIPTION OF THE PREFERRED EMBODIMENTS

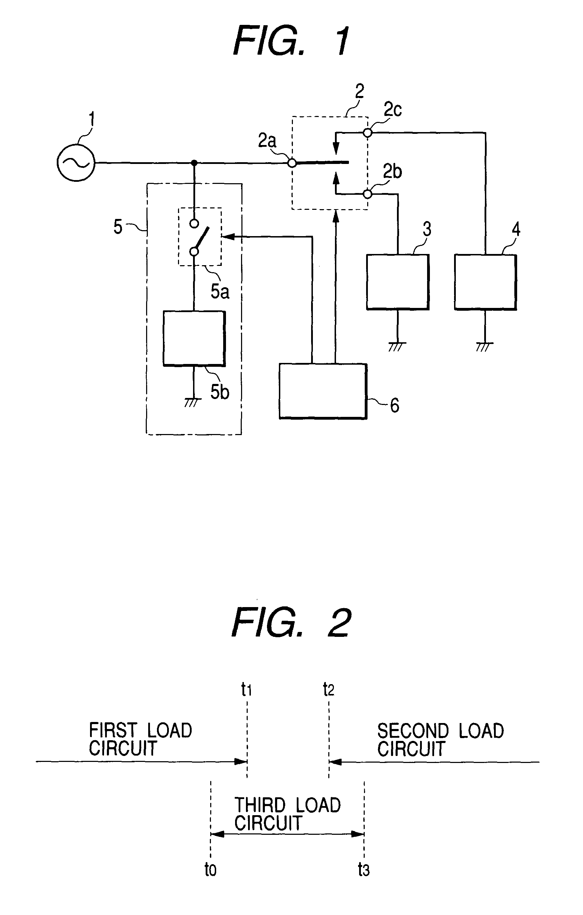

FIG. 1 shows a switching circuit in a first embodiment of the present invention. A signal output from a signal source 1 is provided to a first load circuit 3 or a second load circuit 4 via switching means 2. The signal source 1 is structured by a voltage control oscillator, for example. The switching means 2 is the one structured by a switch circuit of a single-pole double-throw type, for example. Therein, provided are an input terminal 2a connected to the signal source 1, and output terminals 2b and 2c connected to the load circuits 3 and 4, respectively. The input terminal 2a is connected to either the output terminal 2b or 2c. In a case where the input terminal 2a is connected to the output terminal 2b but is to be connected to the output terminal 2c, it takes about 1 µS (micro second) for the input terminal 2a to be cut off from the output terminal 2b and connected to the output terminal 2c. During this switching period, the input terminal 2a is connected neither the output terminal 2b nor 2c.

Provided between the signal source 1 and the switching means 2 is emission attenuation means 5, which is connected between the input terminal 2a of the switching means 2 and the ground. The emission attenuation means 5 includes open/close means 5a and a third load circuit 5b, those of which are connected serially. The third load circuit 5b is preferably about the same in impedance with the first and second load circuits 3 and 4. Although the first and second load circuits 3 and 4 are generally equal in impedance, if different, the values are averaged for use therefor . The open/close means 5a is generally open, and responding to a switching signal coming from a switching control circuit 6, temporarily closes in synchronization with the switching operation of the switching means 2.

To be specific, assuming that the input terminal 2a is cut off from the output terminal 2b at time t1, for example, the switching means 2 will be closed in a time period from immediately before the cut-off, e.g., time to 0.2 µS before, to immediately after time t2, e.g., time t3 0.2 µS after, at which the connection is established with the output terminal 2c. Therefore, the temporal change of the load circuit connected to the signal source 1 looks as shown in FIG. 2. As is known therefrom, the first and third load circuits 3 and 5b are both connected to the signal source 1 in a time period from time to to time t1, and in a time period from times t2 to t3, connected are the second and third load circuits 4 and 5b.

Accordingly, the input terminal 2a of the switching means 2 never opens, and thus a half the impedance of the connected two load circuits will do to terminate. This reduces the load fluctuation of the signal source, and as a result, the signal emission from the input terminal 2a is decreased. Further, using a voltage control oscillator as the signal source 1 will also reduce the load fluctuation, leading to less fluctuation of the oscillation frequency. What is better, the input terminal 2a does not open so that the reflection amount toward the signal source 1 is reduced. Thus, the signal source 1 operates stably.

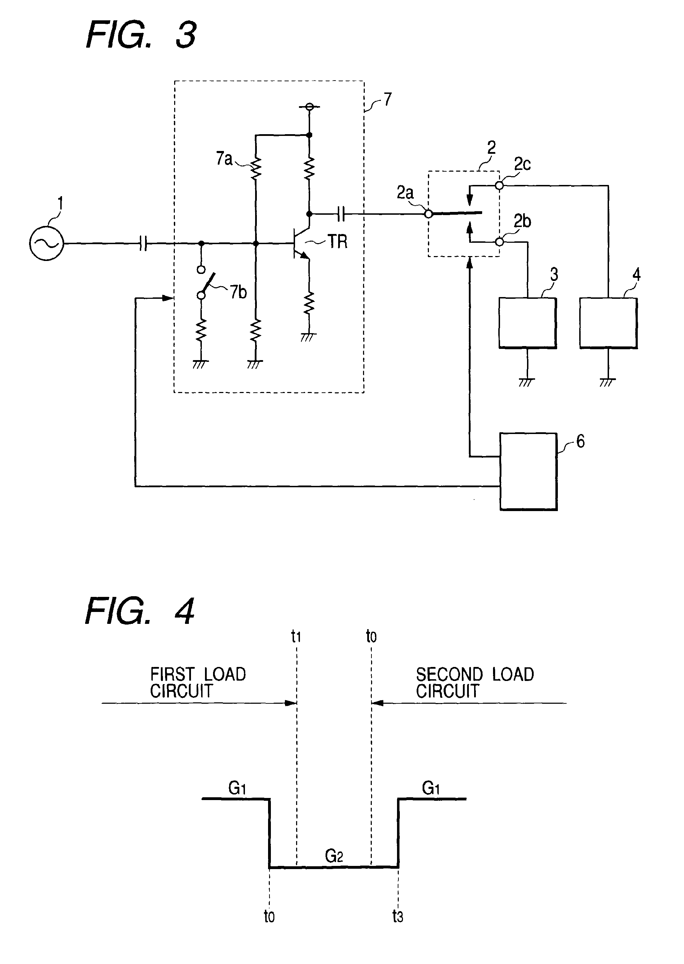

FIG. 3 shows a second embodiment. Provided between the signal source 1 and the switching means 2 is emission attenuation means 7, which includes an amplifier 7a and open/close means 7b for switching base bias voltage of an amplification element TR in the amplifier 7a. In the amplifier 7a, an output terminal is connected to the input terminal 2a of the switching means 2. The open/close means 7b is generally open, but temporarily closed in synchronization with the switching operation of the switching means 2 in response to a switching signal coming from the switching control circuit 6.

To be specific, assuming that the input terminal 2a is cut off from the output terminal 2b at time t1, for example, the switching means 2 will be closed in a time period from immediately before the cut-off, e.g., time to 0.2 µS before, to immediately after time t2, e.g., time t3 0.2 µS after, at which the connection is established with the output terminal 2c. Therefore, in the time period, the base bias voltage of the amplification element TR is reduced, leading gain attenuation. As to the amplifier 7a, the temporal change of the gain looks as shown in FIG. 4. As is known therefrom, the gain remains G1 to time t0, is reduced to G2 from time t0 to t3, and is increased to G1 after time t3. As a result, in the time period from time t0 to t3, the signal emission from the input terminal 2a is reduced in level. Moreover, thanks to the amplifier 7a located between the signal source 1 and the switching means 2, the signal source 1 does not suffer large load fluctuation, and the reflection toward the signal source 1 is small in amount. Thus, the signal source 1 operates stably.

As described in the foregoing, the switching circuit of the present invention is provided with switching means for connecting a signal source to a first load circuit or a second load circuit. Emission attenuation means is provided for attenuating a signal to be emitted from the switching means is provided between the signal source and the switching means in a time period between the signal source being cut off from either the first or second load circuit and being connected to the other. Accordingly, this stops signal jumping to other circuits, successfully reducing the signal level, and preventing other circuits from being blocked.

Further, the emission attenuation means includes a third load circuit, and the third load circuit is connected to the signal source in a time period at least before the signal source being cut off from either the first or second load circuit to after being connected to the other. Therefore, the signal source never opens, successfully not receiving large load fluctuation, and operating stably.

Still further, an impedance of the third load circuit is so set as to be almost an average value between an impedance of the first load circuit and an impedance of the second load circuit. Thus, the load fluctuation can be suppressed to be small.

Still further, the emission attenuation means includes an amplifier, and a gain of the amplifier is attenuated in the time period at least before the signal source being cut off from either the first or second load circuit to after being connected to the other. This reduces signal emission in the switching period, successfully reducing the load fluctuation to the signal source side.

Still further, the gain of the amplifier is attenuated by changing a bias voltage of an amplification element in the amplifier. This makes the gain change easier.

Still further, the signal source is structured by a voltage control oscillator. Accordingly, no fluctuation occurs to the oscillation frequency in a time period for load circuit change.

## Claims

1. A switching circuit, comprising
a signal source; and
switching means for connecting the signal source to a first load circuit or a second load circuit, wherein
between the signal source and the switching means, emission attenuation means is provided for attenuating a signal to be emitted from the switching means in a time period at least between the signal source being cut off from either the first or second load circuit and being connected to the other.

2. The switching circuit according to claim 1, wherein the emission attenuation means includes a third load circuit, and the third load circuit is connected to the signal source in a time period at least before the signal source being cut off from either the first or second load circuit to after being connected to the other.

3. The switching circuit according to claim 2, wherein an impedance of the third load circuit is so set as to be almost an average value between an impedance of the first load circuit and an impedance of the second load circuit.

4. The switching circuit according to claim 1, wherein the emission attenuation means includes an amplifier, and a gain of the amplifier is attenuated in a time period at least before the signal source being cut off from either the first or second load circuit to after being connected to the other.

5. The switching circuit according to claim 4, wherein the gain of the amplifier is attenuated by changing a bias voltage of an amplification element in the amplifier.

6. The switching circuit according to any one of claims 1 to 5, wherein the signal source is structured by a voltage control oscillator.
